# EUROPÄISCHE PATENTSCHRIFT

(11) **EP 0 634 066 B1**
(45) Veröffentlichungstag und Bekanntmachung des Hinweises auf die Patenterteilung: **27.09.2000**
(21) Anmeldenummer: 93903711.5
(22) Anmeldetag: 02.03.1993
(51) Int. Cl.: H03B 5/18

(54) **OSZILLATOR FÜR EINE FREQUENZ VON 1,6 BIS 3 GHz**
1.6 TO 3 GHz OSCILLATOR
OSCILLATEUR POUR UNE FREQUENCE DE 1.6 A 3 GHz

(30) Priorität: 03.04.1992 AT 69292
(43) Veröffentlichungstag der Anmeldung: 18.01.1995
(73) Patentinhaber: Siemens Aktiengesellschaft Österreich, 1210 Wien (AT)
(72) Erfinder: VEITH, Peter, Ernst, A-1190 Wien (AT); GILA, Janos, A-1170 Wien (AT)
(74) Vertreter: Peham, Alois, Dipl.-Ing.
(86) Internationale Anmeldenummer: AT9300033
(87) Internationale Veröffentlichungsnummer: WO9320615

(56) Entgegenhaltungen:
- EP-A- 0 267 100
- GB-A- 2 189 101
- US-A- 4 709 409

## Beschreibung

Die Erfindung betrifft einen Oszillator für eine Frequenz von 1,6 bis 3 GHz mit einer spannungsgesteuerten Resonatoreinheit von einer Schwingstufe sowie mit einer nachgeschalteten Pufferstufe.

Ein derartiger Oszillator für eine Frequenz von 1,6 bis 3 GHz ist beispielsweise bei tragbaren, mobilen oder stationären Kommunikationssystemen einsetzbar. Beispielsweise für Fernwirksysteme oder Meßsysteme insbesondere bei Frequenzen von 2,4 bis 2,5 GHz kann ein Einsatz vorgesehen sein.

Aus der US-A-4 709 409 ist ein Oszillator für eine Frequenz von 1,43 bis 2,23 GHZ bekannt, der eine spannungsgesteuerte Resonatoreinheit, eine Schwingstufe und eine Pufferstufe umfaßt und bei dem ein Resonator der Resonatoreinheit eine Wellenlänge aufweist, die kleiner Lambda/Viertel ist.

In der Patentschrift US 4 990 865, 14. März 1990, "Transistor Microwave Oscillator Having Adjustable Zone of Potential Instability", M. Martheli, ist ein Schwingtransistor in einer Kollektorschaltung angegeben, in dessen Emitterzeig ein Abgleichnetzwerk zur Stabilisierung erforderlich ist. In der Patentschrift US 4 990 866, 14. März 1990, "Voltage Controlled Microwave Oscillator Using a Varactor as Inductance", M. Martheli, ist ein aufwendiges Abgleichnetzwerk angegeben mit drei seriellen Kapazitätsdioden sowie mehreren Abgleichelementen von einer Resonatoreinheit für eine Schwingstufe. Die Die Gehäuseanordnung der Kapazitätsdioden ist ausgelegt für im Verhältnis zur Oszillatorfrequenz niedrigere Frequenzen, sodaß deren parasitäre Induktivitäten bei der vorgesehenen Oszillatorfrequenz nicht vernachlässigbar sind.

Es ist Aufgabe der Erfindung eine weitere Schaltungsanordnung für einen Oszillator anzugeben, welcher insbesondere bei einer Frequenz von 1,6 bis 3 GHz einsetzbar ist. Eine Anordnung in einem Standardgehäuse, sowie eine kostengünstige Serienfertigung soll erzielbar sein. Ein Einsatz bei Mobiltelefonen oder anderen Kommunikationssystemen soll kostengünstig erzielbar sein.

Diese Aufgabe ist gelöst bei einem Oszillator für eine Frequenz von 1,6 bis 3 GHz mit einer spannungsgesteuerten Resonatoreinheit von einer Schwingstufe sowie mit einer nachgeschalteten Pufferstufe, bei welchem ein Resonator der Resonatoreinheit als geätzte Struktur vorgesehen ist in Form eines offenen weniger Lambda/Viertel Resonators, sodaß ein Resonatoranschlußpunkt des Resonators verkoppelt ist einerseits mit einer spannungsgesteuerten Kapazitätsdiode der Resonatoreinheit sowie andererseits mit einem Schwingtransistor der Schwingstufe.

Der Erfindung liegt die Idee zugrunde, daß ein offener weniger Lambda/Viertel Resonator als geätzte Struktur eine derart geringe Frequenzstreuung aufweist, sodaß in vorteilhafter Weise ein besonderer Frequenzabgleich nicht erforderlich ist. Die geätzte Struktur des Resonators kann beispielsweise eine Mikrostreifenleitung oder auch beispielsweise als eine Koplanarstruktur oder als eine Schlitzstruktur vorgesehen sein, also beispielsweise bei Monolith-Technik oder bei Hybrid-Technik.

Durch die Ausbildungsform als ein weniger Lambda/Viertel Resonator ist eine verteilte Resonatorfunktion gegeben. Bauteile beispielsweise bei der Resonatoreinheit, welche für eine niedrigere Frequenz konzipiert sind, können mit ihren parasitären Eigenschaften zur Resonatorfunktion entscheidend beitragen. Es können somit kostengünstige Bauteile eingesetzt werden. Insbesondere parasitäre Induktivitäten von Bonding-Anschlußdrähten im Kapazitätsdiodengehäuse, sowie eine parasitäre Kapazität der Gehäuseform des Kapazitätsdiodengehäuses, sowie parasitäre Induktivitäten von den Kondensatoren sind diesbezüglich besonders geeignet.

Besonders vorteilhaft ist, daß bei dieser verteilten Resonatorfunktion zufolge der parasitären Eigenschaften von kostengünstigen Bauteilen die erforderliche Stabilität erzielbar ist, ohne daß ein aufwendiges Resonatornetzwerk mit besonderen Abgleichfunktionen eingesetzt werden muß. Diese einfache Anordung mit einem offenen weniger Lambda/Viertel Resonator erbringt somit große Vorteile beispielsweise bei einer Serienfertigung, da Abgleichfunktionen insbesondere bei der Resonatoreinheit nicht erforderlich sind. Dieser einfache Oszillator ist insbesondere für Frequenzen von 1,6 bis 3 GHz bei Serienfertigung besonders vorteilhaft gegenüber anderen bekannten Oszillatoren in diesem beispielsweise für Mobiltelefone interessanten Frequenzbereich.

Ausführbar ist ein Oszillator, bei welchem der Resonator in Form eines offenen weniger Lambda/Viertel Streifenleiterresonators angeordnet ist.

In vorteilhafter Weise ist dadurch ein Aufbau des Oszillators beispielsweise mittels SMD-Technik erleichtert, indem für den offenen weniger Lambda/Viertel Streifenleiterresonator eine vorteilhaft einfach herstellbare Struktur vorgesehen ist.

Ausführbar ist ein Oszillator, bei welchem in einer Kollektorschaltung ein bipolarer Transistor der Schwingstufe als der Schwingtransistor vorgesehen ist,
- indem eine Basis des Schwingtransistors verbunden ist mit dem Resonatoranschlußpunkt,
- indem ein Emitter des Schwingtransistors verbunden ist mit einem ersten Ende von einem Rückkopplungsstreifenleiter der Schwingstufe, dessen zweites Ende bei einer offenen Ausführungsform des Rückkopplungsstreifenleiters seriell über eine erste Spule der Schwingstufe und einen ersten Resistor der Schwingstufe verbunden ist mit einem Bezugspotential,
- indem ein Kollektor des Schwingtransistors verbunden ist mit der Pufferstufe.

In einer vorteilhaften Weise ist bei dem schwierigen Frequenzbereich von 1,6 bis 3 GHz eine einfache Schwingstufe einsetzbar, indem ein frequenzbestimmendes Element in Form des offenen Rückkopplungsstreifenleiters im Emitterzweig angeordnet ist, sodaß aufgrund der geringen Frequenzstreuung besondere aufwendige Abgleichfunktionen entfallen können. Bedingt durch die verteilte Resonatorfunktion ist somit auch bei der Schwingstufe eine besonders einfache Anordnung gegeben mit einer guten Stabilität, sodaß der Oszillator ohne Abgleichfunktion aufgebaut werden kann. Der Rückkopplungsstreifenleiter verursacht aufgrund seiner offenen Ausführungsform, nur eine ausreichend kleine Frequenzstreuung. Weitere Vorteile zur Erzielung einer einfachen Anordnung ergeben sich daraus, daß beim Rückkopplungsstreifenleiter insbesondere durch seine offene Ausführungsform gleichspannungsmäßig Verbindung gegeben ist. Das Bezugspotential soll insbesondere Masse sein. Beispielsweise ein Gehäuse des Oszillators kann als Bezugspotential dienen.

Weitere Vorteile ergeben sich daraus, daß durch die direkte Verbindung mit dem Emitter beim Rückkopplungsstreifenleiter eine verteilte kapazitive Rückkopplung wirkt. Von der Basis aus gesehen bildet der Rückkopplungsstreifenleiter bei der Oszillatorfrequenz einen negativen Widerstand.

In vorteilhafter Weise ist somit frequenzbestimmend vorgesehen, daß der offene weniger Lambda/Viertel Resonator, also beispielsweise der Streifenleiterresonator, und der Rückkopplungsstreifenleiter über den Schwingtransistor zusammenwirken. Bei vorgesehenem Frequenzbereich für die Oszillatorfrequenz soll zumindest vergleichsweise der Streifenleiterresonator niederohmig sein, um eine hohe Güte zu erreichen. Die Strukturen der beiden Streifenleiter können in vorteilhafter Weise durch einfaches Ätzen ihrer Mikro-Stripline-Form mit der erforderlichen Genauigkeit einfach hergestellt werden. In diesem Fall wird die Oszillatorfrequenz nur noch hauptsächlich durch Toleranzwerte von verwendeten Bauelementen beeinflußt, die sich jedoch auf die Resonatorfrequenz nicht gravierend auswirken.

Ausführbar ist ein Oszillator,
- bei welchem der Kollektor verbunden ist über einen zweiten Resistor der Schwingstufe mit der Basis,
- bei welchem die Basis verbunden ist über einen dritten Resistor der Schwingstufe mit dem Bezugspotential,
- bei welchem der Kollektor verbunden ist über eine zweite Spule der Schwingstufe mit einem Spannungsversorgungspunkt der Schwingstufe,
- bei welchem der Spannungsversorgungspunkt über einen Filterkondensator der Schwingstufe verbunden ist mit dem Bezugspotential,
- bei welchem mittels des ersten, zweiten und dritten Resistors eine nichtübersteuerte Betriebsart des Schwingtransistors vorgesehen ist.

In einer vorteilhaften Weise ist eine einfache Anordnung beim Schwingtransistor erzielbar. Mit einfachen Mittel und mit minimalem Aufwand kann in vorteilhafter Weise eine Frequenzstabilität erzielt werden, insbesondere für zulässige Temperaturschwankungen oder Schwankungen bei der Versorgungsspannung.

Weitere Vorteile ergeben sich daraus, daß insbesondere eine aktive Stromquelle zur Bildung der Versorgungsspannung nicht erforderlich ist. Dadurch ist insbesondere auch eine niedrige Versorgungsspannung möglich. Dies ist beispielsweise bei mobilen Kommunikationseinrichtungen von großem Vorteil.

Insbesondere soll der Arbeitspunkt des Schwingtransistors für eine nichtübersteuerte Betriebsart des Schwingtransistors eingestellt werden. Dies erfolgt in einer einfachen Weise mittels des ersten, zweiten und dritten Resistors. Zur Erzielung der einfachen Anordnung wird dabei in vorteilhafter Weise ausgenützt, daß der Emitter über den Rückkopplungsstreifenleiter gleichspannungsmäßig seriell verbunden ist mit der ersten Spule und dem ersten Resistor.

Diese serielle Anordnung im Emitterzweig kann beispielsweise auch so erfolgen, daß der Emitter mit dem Rückkopplungsstreifenleiter verbunden ist, welcher mit der ersten Spule verbunden ist, welche mit dem ersten Resistor verbunden ist. Möglich, jedoch fallweise weniger günstig, ist eine serielle Anordnung im Emitterzweig im Sinne des Vertauschens von erster Spule und erstem Resistor.

Weitere Vorteile ergeben sich daraus, daß der Kollektor mit der zweiten Spule direkt verbunden ist. Der Kollektor ist bei der vorgesehenen Oszillatorfrequenz niederohmig, während Basis und Emitter zumindest vergleichsweise hochohmig sind. Dies ist günstig beim Auskoppeln zur nachgeschalteten Pufferstufe. Daraus ergeben sich zusätzliche Vorteile für die Leistungsabgabe der Schwingstufe des Oszillators.

In vorteilhafter Weise ist diese einfache Anordnung bei der Schwingstufe insbesondere aufgrund der verteilten Resonatorfunktion günstig. Insbesondere bei den Resistoren und Spulen können kostengünstige Bauteile eingesetzt werden, indem auch deren parasitäre Eigenschaften genützt werden. Dies betrifft beispielsweise auch den Spannungsteiler für die Basis, also den zweiten und dritten Resistor. Eine hochfrequenzmäßige Entkopplung bei der Basisspannung kann entfallen, oder beispielsweise auch anhand von parasitären Kapazitäten von Spulen zumindest teilweise vorgesehen sein.

Ausführbar ist ein Oszillator,
- bei welchem der Anschlußpunkt des Resonators über einen Koppelkondensator der Resonatoreinheit verbunden ist mit einem Steuerspannungsanschlußpunkt der Kapazitätsdiode, deren anderes Ende mit dem Bezugspotential verbunden ist,
- bei welchem ein Steuerspannungseingabepunkt der Resonatoreinheit über einen Resistor der Resonatoreinheit mit dem Steuerspannungsanschlußpunkt verbunden ist,
- bei welchem der Steuerspannungseingabepunkt über einen Filterkondensator der Resonatoreinheit mit dem Bezugspotential verbunden ist.

In einer vorteilhaften Weise ist diese einfache Anordung anhand der verteilten Resonatorfunktion erzielbar. Bei der Kapazitätsdiode kann ein kostengünstiger Bauteil eingesetzt werden. Es können parasitäre Eigenschaften der Kapazitätsdiode genutzt werden, insbesondere parasitäre Induktivitäten, beispielsweise in Form eines in der Kapazitätsdiode vorgesehenen parasitären Serienschwingkreises. Insbesondere dieser soll bei der verteilten Resonatorfunktion zur Kompensation dienen für den vorgesehenen weniger Lambda/Viertel Resonator.

Der Koppelkondensator dient zur gleichspannungsmäßigen Trennung zwischen Kapazitätsdiode und Resonator. Falls also beispielsweise der Schwingtransistors mit dem Resonator direkt verbunden ist, soll der Koppelkondensator zur gleichspannungsmäßigen Trennung zwischen Kapazitätsdiode und Resonator dienen. Falls beispielsweise diese gleichspannungsmäßige Trennung nicht in dieser Weise vorgesehen oder erforderlich ist, kann der Koppelkondensator weggelassen werden, also beispielsweise indem die Kapazitätsdiode mit dem Resonator direkt verbunden wird. Möglich, jedoch fallweise weniger günstig, bei erforderlicher gleichspannungsmäßiger Trennung zwischen Kapazitätsdiode und Schwingtransistor kann es sein, daß der Koppelkondensator zwischen dem Resonator und dem Schwingtransistor angeordnet wird zur gleichspannungsmäßigen Trennung mit hochfrequenzmäßiger Kopplung von Resonator und Schwingtransistor. Zusätzlich kann dabei ein weiterer Koppelkondensator zur Kopplung des Resonators mit der Kapazitätsdiode vorgesehen sein.

In vorteilhaft einfacher Weise bilden der Resistor der Resonatoreinheit und der Filterkondensator eine Filterfunktion von der Kapazitätsdiode zum Steuerspannungsanschlußpunkt.

Weitere Vorteile ergeben sich daraus, daß kostengünstige beispielsweise SMD-Bauteile verwendet werden können, deren Gehäuseanordnung und darin befindliche Anschlußdrähte für im Vergleich zur Oszillatorfrequenz niedrigere Frequenzen ausgelegt sind, sodaß bei der Oszillatorfrequenz nicht vernachlässigbare parasitäre Induktivitäten und Kapazitäten für die verteilte Resonatorfunktion des Oszillators genutzt werden können. Insbesondere durch die vorteilhaft geringe Anzahl von erforderlichen Bauelementen ist eine Abschätzung der parasitären Effekte erleichtert.

Besonders hingewiesen wird darauf, daß die angegebene Kombination von Merkmalen für die Schwingstufe sowie ihrer Resonatoreinheit für den schwierigen Frequenzbereich von 1,6 bis 3 GHz eine überraschend einfache Anordnung ergibt, bei welcher aufwendige Abgleichnetzwerke und aufwendige Abgleichfunktionen nicht vorgesehen sind, indem bei verteilter Resonatorfunktion in vorteilhaft einfacher Weise mittels eines minimalen Aufwandes der offene weniger Lambda/Viertel Streifenleiterresonator mit dem offenen Rückkopplungsstreifenleiter zusammenwirkt. Für diese beiden Streifenleiter ist in vorteilhafter Weise eine ausreichend niedrige Frequenzstreuung bei der Herstellung erzielbar, sodaß Abgleichfunktionen entfallen können. Der als verteilte Kapazität wirkende offene Rückkopplungsstreifenleiter ist gleichspannungsmäßig seriell verbindend im Emitterkreis vorgesehen, sodaß ein vorteilhaft minimaler Einfluß auf die Reproduzierbarkeit der Schwingfrequenz gegeben ist. Ausgezeichnete Schwingeigenschaften mit hoher Ausgangsleistung bei hoher Reproduzierbarkeit der Schwingfrequenz sind unter Verwendung kostengünstiger aktiver und passiver Bauelemente erzielbar. Bei einem hohen Wirkungsgrad und niedriger Versorgungsspannung sowie Eliminierung von jedem Frequenzabgleich ist nur minimaler Aufwand erforderlich zur Frequenzstabilisierung bezüglich zulässiger Schwankungen der Temperatur und der Versorgungsspannung. Bei nichtübersteuerter Betriebsart des Schwingtransistors ist eine aktive Stromquelle, beispielsweise in Form eines Stromversorgungstransistors im Kollektorzweig, nicht erforderlich. Es ist somit auch eine nur niedrige Versorgungsspannung möglich. Beispielsweise eine 3 Volt Batteriespannung kann fallweise bereits ausreichend sein.

Ausführbar ist ein Oszillator, bei welchem ein GaAs-Transistorverstärker der Pufferstufe in einer nichtübersteuerten Betriebsart vorgesehen ist.

In vorteilhafter Weise ist die Schwingstufe derart leistungsstark, daß in der nachfolgenden Pufferstufe in einer nichtübersteuerten Betriebsart ein GaAs-Transistorverstärker eingesetzt werden kann, dessen gute Eigenschaften seines Großsignalverhaltens genutzt werden können.

Besondere Vorteile ergeben sich bei einer schaltungsspezifischen Auswahl insbesondere der aktiven Komponenten, indem ein besonders rauscharmer Betrieb insbesondere anhand der nichtübersteuerten Betriebsart erzielbar ist.

Ausführbar ist ein Oszillator, welcher mittels SMD-Technik in einem standardisierbaren Gehäuse angeordnet ist.

In einer vorteilhaften Weise sind bei guter Stabilität des Oszillators derart wenige Bauteile erforderlich, sodaß der Oszillator insbesondere mittels SMD-Technik (surface mounted device) in einem Standard-Gehäuse angeordnet werden kann. Es ist eine einfache Schwingstufe mit einfacher Resonatoreinheit vorgesehen, mittels welcher eine bereits ausreichende Leistungsabgabe stabil erzielbar ist, sodaß eine Pufferstufe ausreicht. Weitere Vorteile ergeben sich daraus, daß insbesondere kostengünstige SMD-Bauteile verwendet werden können, da eine verteilte Resonatorfunktion unter Nutzung der parasitären Eigenschaften dieser Bauteile vorgesehen ist.

Besonders hingewiesen wird darauf, daß diese angegebene Kombination der Merkmale für den Oszillator für den schwierigen Frequenzbereich von 1,6 bis 3 GHz eine überraschend einfache Anordnung ergibt, welche bei ihren kleinen Abmessungen in einem Standardgehäuse untergebracht werden kann. Indem jede Abgleichfunktion entfallen kann, ist eine einfache Serienreproduzierbarkeit gegeben.

Es können kostengünstige Bauteile verwendet werden.

Bei hohem Wirkungsgrad, von beispielsweise mehr als 15 %, und hoher Temperaturstabilität ist ein Betrieb mit niedriger Versorgungsspannung, beispielsweise bis 3 Volt, ermöglicht.

Bei niedrigen Phasenrauschwerten und hoher Ausgangsleistung, beispielsweise bis 20 mW, liegt ein großer Abstimmbereich vor, fallweise auch unterhalb oder auch oberhalb des schwierigen Frequenzbereichs von 1,6 bis 3 GHz.

Bevorzugte Ausführungsformen der Erfindung werden anhand der Figuren näher erläutert.
Die Figur 1 zeigt ein Schaltbild des Oszillators.
Die Figur 2 zeigt eine Leiterplatte für SMD-Bauteile.

In Zusammenhang mit den Figuren und der Beschreibung wird folgende Bezugszeichentabelle verwendet.

### Bezugszeichentabelle

- 10: Resonatoreinheit
- 20: Schwingstufe
- 30: Pufferstufe
- S1: Resonator, insbesondere ein offener weniger Lambda/Viertel Streifenleiterresonator
- S2: offener Rückkopplungsstreifenleiter
- S3: Auskopplungsstreifenleiter
- S4: Abgabestreifenleiter
- D1, D2: Kapazitätsdiode
- X1: Resonatoranschlußpunkt
- X2: Steuerspannungsanschlußpunkt der Kapazitätsdiode, insbesondere Kathodenanschlußpunkt der Kapazitätsdiode
- X3: Steuerspannungseingabepunkt der Resonatoreinheit
- X4: Spannungsversorgungspunkt der Schwingstufe
- X5: Spannunngsversorgungspunkt der Pufferstufe
- X6: Auskopplungspunkt der Schwingstufe
- X7, X8: Anodenanschlußpunkt der Kapazitätsdiode
- X9: Rückkopplungsanschlußpunkt des GaAs-Transistorverstärkers
- X10: Bezugspotentialanschlußpunkt des GaAs-Transistorverstärkers
- X11: Abgabepunkt der Pufferstufe
- M: Bezugspotential
- T1: Schwingtransistor der Schwingstufe, insbesondere ein bipolarer Transistor
- B: Basis des Schwingtransistors
- E: Emitter des Schwingtransistors
- C: Kollektor des Schwingtransistors
- T2: GaAs-Transistorverstärker der Pufferstufe
- R1, R2, R3: Resistor der Schwingstufe
- R4: Resistor der Resonatoreinheit
- R5, R6: Resistor der Pufferstufe
- L1, L2: Spule der Schwingstufe
- C1: Filterkondensator der Schwingstufe
- C2: Koppelkondensator der Resonatoreinheit
- C3: Filterkondensator der Resonatoreinheit
- C4: Auskopplungskondensator der Pufferstufe
- C5: Rückkopplungskondensator der Pufferstufe
- C6: Abgabekondensator der Pufferstufe
- C7, C8, C9: Filterkondensator der Pufferstufe
- Q: Gehäuse

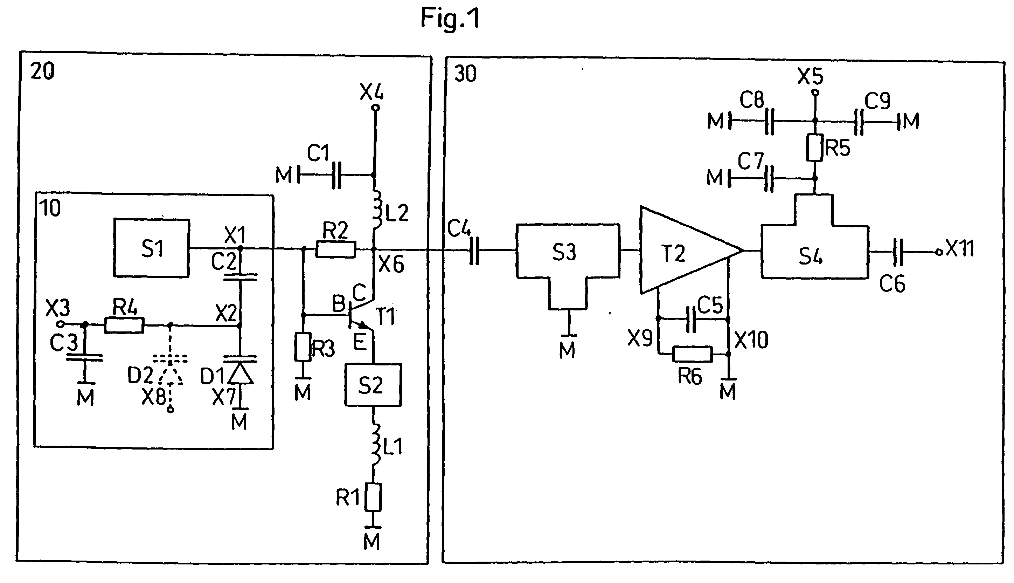

Wie die Fig. 1 zeigt, ist bei einem Ausführungsbeispiel für ein Schaltbild eines Oszillators für eine Frequenz aus dem Frequenzbereich von 1,6 bis 3 GHz eine Resonatoreinheit 10 von einer Schwinstufe 20 vorgesehen, welcher eine Pufferstufe 30 nachgeschaltet ist.

In der Resonatoreinheit 10 ist ein offener weniger Lambda/Viertel Streifenleiterresonator S1 angeordnet mit einem Resonatoranschlußpunkt X1. Der Resonatoranschlußpunkt X1 ist über einen Koppelkondensator C2 der Resonatoreinheit 10 mit einem Steueranschlußpunkt X2 von einer Kapazitätsdiode D1 verbunden. Der Steueranschlußpunkt X2 dient dabei als Kathodenanschlußpunkt X2 der Kapazitätsdiode D1. Ein Anodenanschlußpunkt X7 der Kapazitätsdiode D1 ist mit einem Bezugspotential M verbunden.

Beispielsweise kann vorgesehen sein, daß die Kapazitätsdiode D1 von einem Baustein verwendet wird, welcher zwei Kapazitätsdioden D1, D2 enthält mit identischem Steueranschlußpunkt X2 für beide Kapazitätsdioden D1, D2. In diesem Fall kann vorgesehen sein, daß nur eine Kapazitätsdiode D1 verwendet wird, während die andere Kapazitätsdiode D2 nicht verwendet wird. Ein Anodenanschlußpunkt X8 von der nichtverwendeten Kapazitätsdiode D2 soll in diesem Fall nicht angeschlossen werden, also offen bleiben.

Der Steueranschlußpunkt X2 ist über einen Resistor R4 der Resonatoreinheit 10 mit einem Steuerspannungseingabepunkt X3 der Resonatoreinheit 10 verbunden. Der Steuerspannungseingabepunkt X3 ist über einen Filterkondensaator C3 der Resonatoreinheit 10 mit dem Bezugspotential M verbunden. Am Steuerspannungseingabepunkt X3 ist eine Steuerspannung eingebbar, mittels welcher die Frequenz des spannungsgesteuerten Oszillators steuerbar ist, indem mittels der eingegebenen Steuerspannung ein Kapazitätswert bei der Kapazitätsdiode D1 gesteuert wird.

Als Teil der Schwingstufe 20 ist die Resonatoreinheit 10 am Resonatoranschlußpunkt X1 mit einer Basis B von einem Schwingtransistor T1 der Schwingstufe 20 verbunden. Ein Emitter E des Schwingtransistors T1 ist mit einem Ende von einem offenen Rückkopplungsstreifenleiter S2 verbunden, dessen anderes Ende verbunden ist mit einer ersten Spule L1, welcher ein mit dem Bezugspotential M verbundener erster Resistor R1 der Schwingstufe 20 nachgeschaltet ist.

Ein Kollektor C des Schwingtransistors T1 ist mit einem Auskopplungspunkt X6 der Schwingstufe 20 verbunden. Der Kollektor C ist über eine zweite Spule L2 der Schwingstufe 20 mit einem Spannungsversorgungspunkt X4 der Schwingstufe 20 verbunden. Der Spannungsversorgungspunkt X4 ist über einen Filterkondensator C1 der Schwingstufe 20 mit dem Bezugspotential M verbunden. Am Spannungsversorgungspunkt X4 ist eine Versorgungsspannung der Schwingstufe 20 eingebbar.

Die Basis B des Schwingtransistors T1 ist über einen zweiten Resistor R2 der Schwingstufe 20 mit dem Kollektor C des Schwingtransistors T1 verbunden. Die Basis B des Schwingtransistors T1 ist über einen dritten Resistor R3 der Schwingstufe 20 mit dem Bezugspotential M verbunden.

Bei der Pufferstufe 30 ist zur Auskopplung ein Auskopplungskondensator C4 der Pufferstufe 30 vorgesehen in Verbindung mit einem Auskopplungsstreifenleiter S3 der Pufferstufe 30, welcher gemäß einer geschlossenen Ausführungsform des Auskopplungsstreifenleiters S3 mit dem Bezugspotential M verbunden ist. Der Auskopplungsstreifenleiter S3 dient zur Eingabe für einen GaAs-Transistorverstärker T2 der Pufferstufe 30. Ein Rückkopplungsanschlußpunkt X9 des GaAs-Transistorverstärkers T2 ist über eine parallele Schaltung von einem Rückkopplungskondensator C5 der Pufferstufe 30 und einen Resistor R6 der Pufferstufe 30 mit einem Bezugspotentialanschlußpunkt X10 des GaAs-Transistorverstärkers T2 verbunden. Der Bezugspotentialanschlußpunkt X10 des GaAs-Transistorverstärkers T2 ist mit dem Bezugspotential M verbunden.

Am Ausgang des GaAs-Transistorverstärkers T2 ist ein Abgabestreifenleiter S4 der Pufferstufe 30 vorgesehen, welcher über einen Abgabekondensator C6 der Pufferstufe 30 mit einem Abgabepunkt X11 der Pufferstufe 30 verbunden ist. Der Abgabestreifenleiter S4 ist über einen Filterkondensator C7 der Pufferstufe 30 mit dem Bezugspotential M verbunden. Der Abgabestreifenleiter S4 ist über einen weiteren Resistor R5 der Pufferstufe 30 mit einem Spannungsversorgungspunkt X5 der Pufferstufe 30 verbunden. Fallweise kann vorgesehen sein, daß der Resistor R5 entfällt, also nicht vorgesehen ist, indem der Abgabestreifenleiter S4 mit dem Spannungsversorgungspunkt X5 verbunden wird. Der Spannungsversorgungspunkt X5 ist über einen zweiten Filterkondensator C8 der Pufferstufe 30 mit dem Bezugspotential M verbunden. Der Spannungsversorgungspunkt X5 ist über einen dritten Filterkondensator C9 mit dem Bezugspotential M verbunden. Am Spannungsversorgungspunkt X5 ist eine Versorgungsspannung für die Pufferstufe 30 eingebbar.

Am Abgabepunkt X11 der Pufferstufe 30 ist vorgesehen, daß ein vom Oszillator erzeugtes Oszillatorsignal entnommen wird.

Als die Kapazitätsdiode D1 kann beispielsweise eine von beiden Kapazitätsdioden eines SMD-Bausteins Siemens BBY51 eingesetzt werden.

Als der Schwingtransistor T1 kann beispielsweise ein SMD-Baustein Siemens BFR181 eingesetzt werden, welcher einen bipolaren Transistor enthält.

Als der GaAs-Transistorverstärker T2 kann beispielsweise ein SMD-Baustein Siemens CF750 eingesetzt werden.

Der Oszillator kann beispielsweise mittels SMD-Technik unter Verwendung einer Epoxy-Leiterplatte von 0,8 mm Dicke aufgebaut werden.

Ein derart aufgebauter Oszillator kann beispielsweise in einem Gehäuse KOTO-6 von der Koto Electric Co. angeordnet sein.

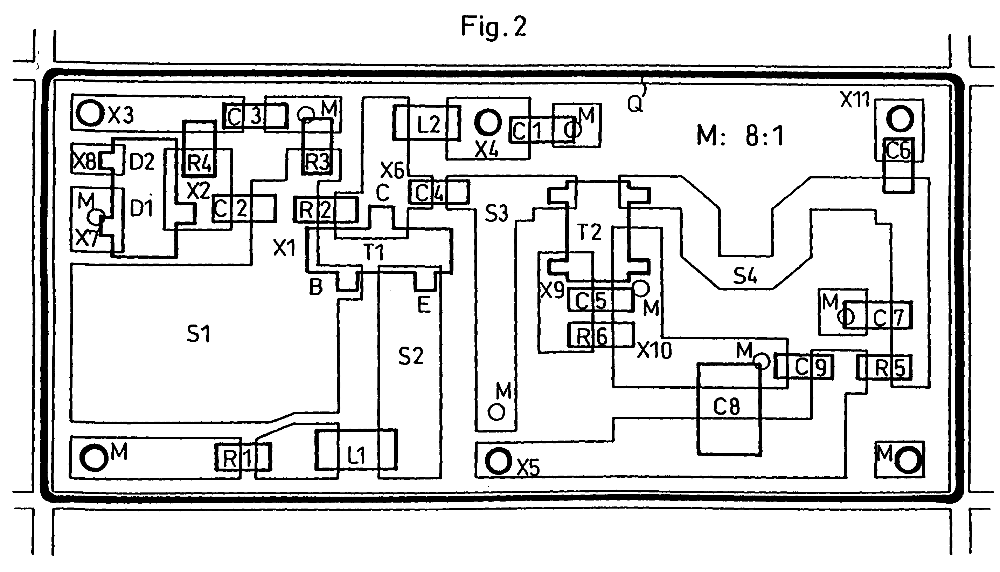

Die Fig. 2 zeigt ein Ausführungsbeispiel für eine Leiterplatte von einem derart aufgebauten Oszillator.

Gemäß einer Abbildung ungefähr im Maßstab 8:1 ist die Bauteileseite der Leiterplatte mit ihren Leiterbahnen dargestellt, auf welchen mittels SMD-Technik die SMD-Bauteile befestigt werden. Es sind insbesondere die Konturen der Leiterbahnen anhand von dünnen Linien angegeben. Die Konturen der vorgesehenen SMD-Bauteile sind in Form von dicken Linien angegeben. Ein Gehäuse Q, insbesondere das Gehäuse KOTO-6 von der Koto Electric Co., soll entlang der äußeren dicken Linie vorgesehen sein. Als Kapazitätsdiodenbaustein mit zwei Kapazitätsdioden D1,D2 soll insbesondere der SMD-Baustein Siemens BBY51 vorgesehen sein. Als Schwingtransistor T1 soll insbesondere der SMD-Baustein Siemens BFR181 vorgesehen sein. Als GaAs-Transistorverstärker T2 soll insbesondere der SMD-Baustein Siemens CF750 vorgesehen sein. Die angegebene Leiterplatte soll insbesondere aus einem Epoxy-Material mit einer Dicke von 0,8 mm gefertigt sein, und auf ihrer Rückseite leitend sein.

Es sind sechs Anschlußstifte vorgesehen, welche in Form von dicken Kreislinien dargestellt sind.

An den Stellen, welche in Form von dünnen Kreislinien markiert sind, soll die auf der Bauteileseite dargestellte Leiterbahn durch die Leiterplatte hindurch mit der leitenden Rückseite der Leiterplatte leitend verbunden werden. Die leitende Rückseite der Leiterplatte soll das Bezugspotential M bilden. Das Bezugspotential M soll insbesondere anlegbar sein an dem links unten in der Figur dargestellten Anschlußstift sowie an dem rechts unten in der Figur dargestellten Anschlußstift. Diese beiden Anschlußstifte sollen mit der leitenden Rückseite der Leiterplatte leitend verbunden sein. Die anderen vier dargestellten Anschlußstifte sollen nicht mit der leitenden Rückseite der Leiterplatte verbunden sein.

An dem links oben in der Figur dargestellten Anschlußstift soll die Steuerspannung für den spannungsgesteuerten Oszillator zugeführt werden. An dem in der Figur oben in der Mitte dargestellten Anschlußstift soll die Versorgungsspannung der Schwingstufe zugeführt werden. An dem in der Figur unten in der Mitte dargestellten Anschlußstift soll die Versorgungsspannung für die Pufferstufe zugeführt werden. An dem in der Figur rechts oben dargestellten Anschlußstift soll das Oszillatorsignal entnommen werden.

Zur Erläuterung der Funktionsweise des Oszillators wird darauf hingewiesen, daß der Schwingtransistor T1 in einer Kollektorschaltung angeordnet ist. Über den Auskopplungskondensator C4 erfolgt eine niederohmige Auskopplung. Der Emitter E des Schwingtransistors T1 ist mit einem offenen Rückkopplungsstreifenleiter S2 verbunden. Dadurch ergibt sich für einen breiten Frequenzbereich ein negativer Widerstand von der Basis B des Schwingtransistors T1 aus gesehen. Gleichspannungsmäßig wird der Arbeitspunkt des Schwingtransistors T1 durch die Resistoren R1, R2 und R3 eingestellt, sodaß eine nichtübersteuerte Betriebsart des Schwingtransistors T1 vorgesehen ist. Mittels der Spulen L1 und L2 sowie mit Hilfe des Filterkondensator C1 ist eine hochfrequenzmäßige Entkopplung des Schwingtransistors T1 vorgesehen. Die Basis B des Schwingtransistors T1 ist am Resonatoranschlußpunkt X1 mit einer elektrisch abzustimmenden Resonatoreinheit verbunden. Diese besteht aus einem offenen weniger Lambda/Viertel Streifenleiterresonator S1, welcher über einen Koppelkondensator C2 mit der Kapazitätsdiode D1 verbunden ist. Dadurch wird die Entstehung von Schwingungen auf einer charakteristischen Frequenz dieser Resonatoreinheit bewirkt. Über den Resistor R4 sowie den Filterkondensator C3, welche als RC-Filter wirken, ist am Steuerspannungseingabepunkt X3 eine Steuerspannung eingebbar, welche zur frequenzbestimmenden Ansteuerung dieser Resonatoreinheit dient, indem gemäß dieser Steuerspannung der Kapazitätswert der Kapazitätsdiode D1 gesteuert wird. Der Anodenanschlußpunkt X8 von der Kapazitätsdiode D2 bleibt dabei offen, sodaß die Kapazitätsdiode D2 dabei insbesondere nicht verwendet wird.

Ein Teil der in dieser Schwingstufe schwingenden Energie wird über den Auskopplungskondensator C4 und den Auskopplungsstreifenleiter S3 vom GaAs-Transistorverstärker T2 übernommen und steht gepuffert und verstärkt an dessen Ausgang, impedanzmäßig angepaßt durch den Abgabestreifenleiter S4. Die Resistoren R4 und R5 bestimmen den Arbeitspunkt des GaAs-Transistorverstärkers T2, insbesondere für eine nicht übersteuerte Betriebsart. Anhand der Kondenstoren C5, C6, C7, C8, C9 erfolgen Auskopplungsfunktionen, Entkopplungsfunktionen sowie Filterfunktionen.

Bei einem derart mittels SMD-Technik aufgebauten Oszillator, bei welchem insbesondere keine Keramik-Technologie, kein Bonding, keine Dünnschicht-Technologie vorgesehen ist, und welcher insbesondere unter Verwendung herkömmlicher Materialien und Bauelemente aufgebaut werden kann, sind überraschend ausgezeichnete Schwingeigenschaften beobachtbar mit einer hohen Reproduzierbarkeit der Schwingfrequenz, insbesondere in einem Frequenzbereich von 1,6 bis 3,0 GHz. Bei guten thermischen Eigenschaften und geringer Empfindlichkeit gegen Versorgungsspannungsschwankungen kann an den Spannungsversorgungspunkten X4, X5 beispielsweise eine Versorgungsspannung von 3,0 V vorgesehen sein. Bei einem hohen Wirkungsgrad des Oszillators ist eine hohe Ausgangsleistung am Abgabepunkt X11 entnehmbar. Insbesondere aufgrund der nicht übersteuerten Betriebsart von Schwingstufe sowie Pufferstufe kann ein niedriger Seitenbandrauschpegel im Ausgangssignal aufrechterhalten werden.

Dieser kostengünstige Aufbau des Oszillators ist insbesondere dadurch erzielbar, daß bei den verwendeten herkömmlichen SMD-Bauelementen ihre genormten und parasitären Eigenschaften zum Einsatz kommen. Dies betrifft insbesondere eine serielle parasitäre Induktivität der Chipanschlüsse von einer kostengünstigen Kapazitätsdiode D1, welche für diesen hohen Frequenzbereich normalerweise nicht eingesetzt werden soll.

Es wird insbesondere darauf hingewiesen, daß der offene weniger Lambda/Viertel Streifenleiterresonator S1 einerseits sowie andererseits der offene Rückkopplungsstreifenleiter S2 keine Verbindung mit dem Bezugspotential M aufweisen. Insbesondere dadurch ist eine hohe Reproduzierbarkeit gemäß einer niedrigen Frequenzstreuung für diese beiden Streifenleiter gegeben. Beim Ätzvorgang sind die Konturen für diese beiden Streifenleiter ausreichend genau reproduzierbar. Insbesondere daraus ergeben sich die besonderen kostengünstigen Vorteile dieses Oszillators. Dabei können insbesondere kostengünstige SMD-Bauteile verwendet werden, welche normalerweise nicht für einen Oszillator mit einer Oszillatorfrequenz beispielsweise im Frequenzbereich von 1,6 bis 3 GHz vorgesehen sind.

Damit wird bei einem Oszillator für eine Frequenz von 1,6 bis 3 GHz mit einer spannungsgesteuerten Resonatoreinheit von einer Schwingstufe sowie mit einer nachgeschalteten Pufferstufe ein offener weniger Lambda/Viertel Streifenleiterresonator eingesetzt in Kombination mit einem offenen Rückkopplungsstreifenleiter im Emitterzweig einer Kollektorschaltung eines nichtübersteuerten Schwingtransistors. Der Resonator ist insbesondere mit parasitären Schwingkreisen von einer Kapazitätsdiode verkoppelt. Es ist eine besonders einfache und robuste Schaltung für diesen problematischen Frequenzbereich erzielbar mit großer Ausgangsleistung. Eine Anordnung mittels SMD-Technik in einem Standard-Gehäuse ist ohne besondere Abgleichfunktionen ausführbar, insbesondere bei Serienfertigung.

## Patentansprüche

1. Oszillator für eine Frequenz von 1,6 bis 3 GHz mit einer Schwingstufe (20) mit einer zugehörigen spannungsgesteuerten Resonatoreinheit (10), sowie mit einer nachgeschalteten Pufferstufe (30), bei welchem ein Resonator (S1) der Resonatoreinheit (10) in Form eines offenen Resonators (S1) vorgesehen ist, dessen Wellenlänge weniger als ein Lambda/Viertel beträgt und ein Resonatoranschlußpunkt (X1) des Resonators (S1) mit einer spannungsgesteuerten Kapazitätsdiode (D1) der Resonatoreinheit (10) verkoppelt ist **dadurch gekennzeichnet**, daß der Resonatoranschlußpunkt (X1) des als geätzte Struktur ausgeführten Resonators (S1) zusätzlich verkoppelt ist mit einem Schwingtransistor (T1) der Schwingstufe (20).

2. Oszillator nach Anspruch 1, **dadurch gekennzeichnet**, daß der Resonator (S1) als offener Streifenleiterresonator (S1) ausgebildet ist.

3. Oszillator nach Anspruch 1 oder 2, **dadurch gekennzeichnet**, daß in einer Kollektorschaltung ein bipolarer Transistor (T1) der Schwingstufe (20) als Schwingtransistor (T1) vorgesehen ist, dessen Basis (B) mit dem Resonatoranschlußpunkt (X1), dessen Emitter (E) mit einem ersten Ende eines Rückkopplungsstreifenleiters (S2) der Schwingstufe (20) und dessen Kollektor (C) mit der Pufferstufe (30) verbunden ist, und daß, falls der Rückkopplungsstreifenleiter (S2) offen ausgeführt ist, das zweite Ende über eine erste Spule (L1) und einen ersten Resistor (R1) mit einem Bezugspotential (M) verbunden ist.

4. Oszillator nach Anspruch 3, **dadurch gekennzeichnet**, daß zwischen Kollektor (C) und Basis (B) des Schwingtransistors (T1) ein zweiter Resistor (R2) geschaltet ist, daß die Basis (B) über einen dritten Resistor (R3) mit dem Bezugspotential (M) verbunden ist und der Kollektor (C) über eine zweite Spule (L2) mit einem Spannungsversorgungspunkt (X4) verbunden ist, der wiederum über einen Filterkondensator (C1) mit dem Bezugspotential verbunden ist und daß erster, zweiter und dritter Resistor (R1, R2, R3) derartig bemessen sind, daß eine nichtübersteuerte Betriebsart des Schwingtransistors (T1) festgelegt ist.

5. Oszillator nach einem der Ansprüche 1 bis 4, **dadurch gekennzeichnet**, daß der Resonatoranschlußpunkt (X1) über einen Koppelkondensator (C2) der Resonatoreinheit (10) mit einem Steuerspannungsanschlußpunkt (X2) der Kapazitätsdiode (D1) verbunden ist, deren zweiter Anschluß mit dem Bezugspotential (M) verbunden ist, daß der Steuerspannungsanschlußpunkt (X2) der Kapazitätsdiode (D1) weiterhin über einen vierten Resistor R4 der Resonatoreinheit (10) mit einem Steuerspannungseingabepunkt (X3) verbunden ist, der mittels weiterem Filterkondensator (C3) mit dem Bezugspotential (M) verbunden ist.

6. Oszillator nach einem der Ansprüche 1 bis 5, **dadurch gekennzeichnet**, daß die Pufferstufe (30) einen GaAs-Transistorverstärker (T2)in nichtübersteuernder Betriebsart umfaßt.

7. Oszillator nach einem der Ansprüche 1 bis 6, **dadurch gekennzeichnet**, daß der Oszillator in SMD- Technik in einem standardisierbaren Gehäuse (Q) aufgebaut ist.

## Claims

1. Oscillator for a frequency of 1.6 to 3 GHz having an oscillation stage (20) having an associated voltage-controlled resonator unit (10), and also having a buffer stage (30) connected downstream, in which a resonator (S1) of the resonator unit (10) is provided in the form of an open resonator (S1), whose wavelength is less than a lambda/quarter, and a resonator connection point (X1) of the resonator (S1) is coupled to a voltage-controlled variable-capacitance diode (D1) of the resonator unit (10), characterized in that the resonator connection point (X1) of the resonator (S1), which is embodied as an etched structure, is additionally coupled to an oscillation transistor (T1) of the oscillation stage (20).

2. Oscillator according to Claim 1, characterized in that the resonator (S1) is designed as an open stripline resonator (S1).

3. Oscillator according to Claim 1 or 2, characterized in that, in a common-collector configuration, a bipolar transistor (T1) of the oscillation stage (20) is provided as oscillation transistor (T1), whose base (B) is connected to the resonator connection point (X1), whose emitter (E) is connected to a first end of a feedback stripline (S2) of the oscillation stage (20) and whose collector (C) is connected to the buffer stage (30), and in that, if the feedback stripline (S2) is embodied in an open fashion, the second end is connected to a reference-earth potential (M) via a first coil (L1) and a first resistor (R1).

4. Oscillator according to Claim 3, characterized in that a second resistor (R2) is connected between collector (C) and base (B) of the oscillation transistor (T1), in that the base (B) is connected to the reference-earth potential (M) via a third resistor (R3) and the collector (C) is connected via a second coil (L2) to a voltage supply point (X4), which is in turn connected via a filter capacitor (C1) to the reference-earth potential, and in that the first, second and third resistors (R1, R2, R3) are dimensioned in such a way that a non-overdriven operation mode of the oscillation transistor (T1) is established.

5. Oscillator according to one of Claims 1 to 4, characterized in that the resonator connection point (X1) is connected via a coupling capacitor (C2) of the resonator unit (10) to a control voltage connection point (X2) of the variable-capacitance diode (D1), whose second connection is connected to the reference-earth potential (M), in that the control voltage connection point (X2) of the variable-capacitance diode (D1) is furthermore connected via a fourth resistor (R4) of the resonator unit (10) to a control voltage input point (X3), which is connected to the reference-earth potential (M) by means of a further filter capacitor (C3).

6. Oscillator according to one of Claims 1 to 5, characterized in that the buffer stage (30) comprises a GaAs transistor amplifier (T2) in a non-overdriving operating mode.

7. Oscillator according to one of Claims 1 to 6, characterized in that the oscillator is constructed using SMD technology in a standardizable housing (Q).

## Revendications

1. Oscillateur pour une fréquence dé 1,6 à 3 GHz comportant un étage (20) oscillant ayant une unité (10) à résonateur associée, commandée en tension, ainsi que comportant un étage (30) tampon en aval, dans lequel est prévu un résonateur (S1) de l'unité (10) à résonateur sous la forme d'un résonateur (S1) ouvert dont la longueur d'onde est inférieure à un quart d'onde et dans lequel un point (X1) de raccordement du résonateur (S1) est couplé à une diode (D1) capacitive, commandée en tension, de l'unité (10) à résonateur, caractérisé en ce que le point (X1) de raccordement du résonateur (S1) réalisé en structure obtenue par attaque chimique est couplé de plus à un transistor (T1) oscillant de l'étage (20) oscillant.

2. Oscillateur suivant la revendication 1, caractérisé en ce que le résonateur (S1) est réalisé en résonateur (S1) à guide d'ondes à ruban ouvert.

3. Oscillateur suivant la revendication 1 ou 2, caractérisé en ce qu'il est prévu dans un circuit collecteur, comme transistor (T1) oscillant, un transistor (T1) bipolaire de l'étage (20) oscillant dont la base (B) est reliée au point (X1) de raccordement du résonateur, dont l'émetteur (E) est relié à une première extrémité d'un guide (S2) d'ondes à ruban de rétrocouplage de l'étage (20) oscillant et dont le collecteur (C) est relié à l'étage (30) tampon, et en ce que, dans le cas où le guide (S2) d'ondes à ruban de rétrocouplage est réalisé de manière ouverte, la deuxième extrémité est reliée par l'intermédiaire d'une première bobine (L1) et d'une première résistance (R1) à un potentiel (M) de référence.

4. Oscillateur suivant la revendication 3, caractérisé en ce qu'il est branché entre le collecteur (C) et la base (B) du transistor (T1) oscillant une deuxième résistance (R2), en ce que la base (B) est reliée par l'intermédiaire d'une troisième résistance (R3) au potentiel (M) de référence et en ce que le collecteur (C) est relié par l'intermédiaire d'une deuxième bobine (L2) à un point (X4) d'alimentation en tension qui est relié à son tour, par l'intermédiaire d'un condensateur (C1) de filtrage, au potentiel de référence, et en ce que la première (R1), la deuxième (R2) et la troisième (R3) résistance sont dimensionnées de telle manière qu'il est fixé un mode de fonctionnement du transistor oscillant qui n'est pas surmodelé.

5. Oscillateur suivant l'une des revendications 1 à 4, caractérisé en ce que le point (X1) de raccordement du résonateur est relié par l'intermédiaire d'un condensateur (C2) de couplage de l'unité (10) à résonateur à un point (X2) de raccordement de tension de commande de la diode (D1) capacitive dont la deuxième borne est reliée au potentiel (M) de référence, en ce que le point (X2) de raccordement de tension de commande de la diode (D1) capacitive est relié de plus par l'intermédiaire d'une quatrième résistance (R4) de l'unité (10) à résonateur à un point (X3) d'entrée de tension de commande qui est relié au potentiel (M) de référence au moyen d'un condensateur (C3) de filtrage supplémentaire.

6. Oscillateur suivant l'une des revendications 1 à 5, caractérisé en ce que l'étage (30) tampon comporte un amplificateur (T2) à transistor GaAs en mode de fonctionnement non surmodelé.

7. Oscillateur suivant l'une des revendications 1 à 6, caractérisé en ce que l'oscillateur est constitué en technique SMD dans un boîtier (Q) pouvant être normalisé.
